# EUROPEAN PATENT APPLICATION

(11) **EP 3 012 865 A1**
(43) Date of publication of application: **27.04.2016**
(21) Application number: 15168787.8
(22) Date of filing: 22.05.2015
(51) Int. Cl.: H01L 27/32, G02F 1/1347

(54) **DISPLAY PANEL AND DISPLAY DEVICE HAVING THE SAME**

(30) Priority: 21.10.2014 KR 20140142882
(71) Applicant: Samsung Display Co., Ltd., Gyeonggi-do (KR)
(72) Inventor: Lee, Seung-Chang, Gyeonggi-do (KR); Kim, Gee-Bum, Gyeonggi-do (KR); Kim, Ki-Seo, Chungcheongnam-do (KR); Park, Sung-Kook, Gyeonggi-do (KR)
(74) Representative: Mounteney, Simon James

(57) **Abstract**

A display panel includes a first substrate (110) including a transistor (121-127); a pixel electrode (140) electrically connected to the transistor (121-127); a common electrode (160) opposing the pixel electrode (140); an emission layer (150) between the pixel electrode (140) and the common electrode (160), the emission layer (150) emitting light; a second substrate (190) opposing the first substrate (110); a light control electrode (180) on the second substrate (190); and a filling layer (170) between the light control electrode (180) and the common electrode (160), a refractive index of the filling layer (170) being changed based on a potential difference between the light control electrode (180) and the common electrode (160).

## Description

### BACKGROUND

### 1. Field

The invention relates to display devices, for example, to a display panel and a display device having the display panel.

### 2. Description of the Related Art

An organic light emitting display device may display an image using an organic light emitting diode. The organic light emitting diode may include an emission layer between a pixel electrode and a common electrode. Positive holes from the pixel electrode may be combined with electrons from the common electrode in the emission layer between the anode and the pixel electrode, and light may be emitted.

A liquid crystal display device may adjust an arrangement of a liquid crystal layer by an electric field generated by a pixel electrode and a common electrode, and transmittance of light may be controlled and an image may be displayed.

In an organic light emitting display device having a resonance structure, color distortion may occur, for example, due to a difference of optical paths according to viewing angle. In a liquid crystal display device, color distortion may occur, for example, because the arrangement of the liquid crystal may be distorted according to the viewing angle. Methods of forming a hazed film on the display panel may prevent color distortion and may widen the viewing angle. Display devices generated by methods of forming a hazed film may cause a stain and may not variably control the refractive index of the light.

### SUMMARY

Example embodiments provide an organic light emitting display panel that may variably control the refractive index of the light in at least one material of the display panel in the light emitting path.

Embodiments of the invention may be realized by providing a display panel, including a first substrate including a transistor; a pixel electrode electrically connected to the transistor; a common electrode opposing the pixel electrode; an emission layer between the pixel electrode and the common electrode, the emission layer emitting light; a second substrate opposing the first substrate; a light control electrode on the second substrate; and a filling layer between the light control electrode and the common electrode, a refractive index of the filling layer being changed based on a voltage difference between the light control electrode and the common electrode.

The filling layer may include a polymer dispersed liquid crystal (PDLC).

The PDLC may be a positive type liquid crystal.

The PDLC may be a negative type liquid crystal.

The light control electrode may include a first layer including a transparent conductive material.

The first layer may include one or more of indium tin oxide (ITO), indium zinc oxide (IZO), zinc oxide (ZnOₓ), or tin oxide (SnOₓ).

The light control electrode may further include a second layer at least in part on the first layer.

The second layer may include one or more of cupper (Cu), platinum (Pt), aluminum (Al), silver (Ag), molybdenum (Mo), nickel (Ni), or chrome (Cr).

A voltage of the light control electrode may be controlled based on an intensity of ambient illumination.

The first substrate may include a first pixel region, a second pixel region, and a third pixel region that emit different color lights, and the light control electrode may be independently patterned on each of the first pixel region, the second pixel region, and the third pixel region.

Voltages of the light control electrodes corresponding to each of the first pixel region, the second pixel region, and the third pixel region may be independently controlled.

The display panel may further include a protection layer on at least one side of the filling layer.

Embodiments of the invention may also be realized by providing a display device, including a display panel; a scan driver providing a scan signal to the display panel; a data driver providing a data signal to the display panel; and a light controller providing a light control signal to the display panel, the display panel including a first substrate including a transistor providing the data signal in response to the scan signal; a pixel electrode electrically connected to the transistor; a common electrode opposing the pixel electrode; an emission layer between the pixel electrode and the common electrode, the emission layer emitting light; a second substrate opposing the first substrate; a light control electrode on the second substrate, the light control signal being applied to the light control electrode; and a filling layer between the light control electrode and the common electrode, a refractive index of the filling layer being changed based on a voltage difference between the light control electrode and the common electrode.

The filling layer may include a polymer dispersed liquid crystal (PDLC).

The light controller may adjust the light control signal based on an intensity of ambient illumination.

The display panel may include a first pixel region, a second pixel region, and a third pixel region that emit different color lights, and the light control electrode may be independently patterned on each of the first pixel region, the second pixel region, and the third pixel region.

The light controller may independently control voltages of the light control electrodes corresponding to each of the first pixel region, the second pixel region, and the third pixel region.

The display panel may be a top emission type display panel.

Embodiments may be realized by providing a display panel, including a first substrate including a transistor; a pixel electrode electrically connected to the transistor; a second substrate opposing the first substrate; a common electrode on a first side of the second substrate, the common electrode opposing the pixel electrode; a liquid crystal layer between the pixel electrode and the common electrode; a light control electrode on a second side of the second substrate; and a filling layer between the light control electrode and the second substrate, a refractive index of the filling layer being changed based on a voltage difference between the light control electrode and the common electrode.

The filling layer may include a polymer dispersed liquid crystal (PDLC).

A display panel according to example embodiments of the invention may include a filling layer and a light control electrode that may variably control the refractive index of the light and that may improve visibility of a displaying image. The display panel may have one additional electrode (i.e., a light control electrode) that may control the filling layer, and manufacturing costs may be reduced compared to other manners of achieving such features. The display panel may independently control refractive index of a portion, e.g., region, of the display panel by patterning the light control electrode.

The display device according to example embodiments may control a viewing angle and luminance in a certain direction by including the display panel. The display device may emphasize a certain color light or a portion, e.g., region, of the display panel using the patterned the light control electrode.

Example embodiments may be applied to an electronic device having a display device. For example, example embodiments may be applied to a television, a computer monitor, a laptop, a cellular phone, a smart phone, a smart pad, a personal digital assistant (PDA), a portable multimedia player (PMP), a MP3 player, a digital camera, or a video phone.

At least some of the above and other features of the invention are set-out in the claims.

### BRIEF DESCRIPTION OF THE DRAWINGS

Features of the invention will be made more apparent to those of skill in the art by describing in detail embodiments thereof with reference to the attached drawings in which:
FIG. 1 illustrates a block diagram of a display device according to example embodiments of the invention;
FIG. 2 illustrates a cross-sectional view of one example of a display panel included in a display device of FIG. 1;
FIGS. 3A and 3B illustrate cross-sectional views of examples of controlling the filling layer included in a display panel of FIG. 2;
FIG. 4 illustrates a cross-sectional view of another example of a display panel included in a display device of FIG. 1;
FIG. 5 illustrates a cross-sectional view of an example of controlling the filling layer included in a display panel of FIG. 4;
FIG. 6 illustrates a cross-sectional view of still another example of a display panel included in a display device of FIG. 1; and
FIG. 7 illustrates a cross-sectional view of still another example of a display panel included in a display device of FIG. 1.

### DETAILED DESCRIPTION

Example embodiments of the invention will now be described more fully hereinafter with reference to the accompanying drawings; however, the invention may be embodied in different forms and should not be construed as limited to the embodiments set forth herein. Rather, these embodiments are provided so that this disclosure will be thorough and will convey implementations thereof to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

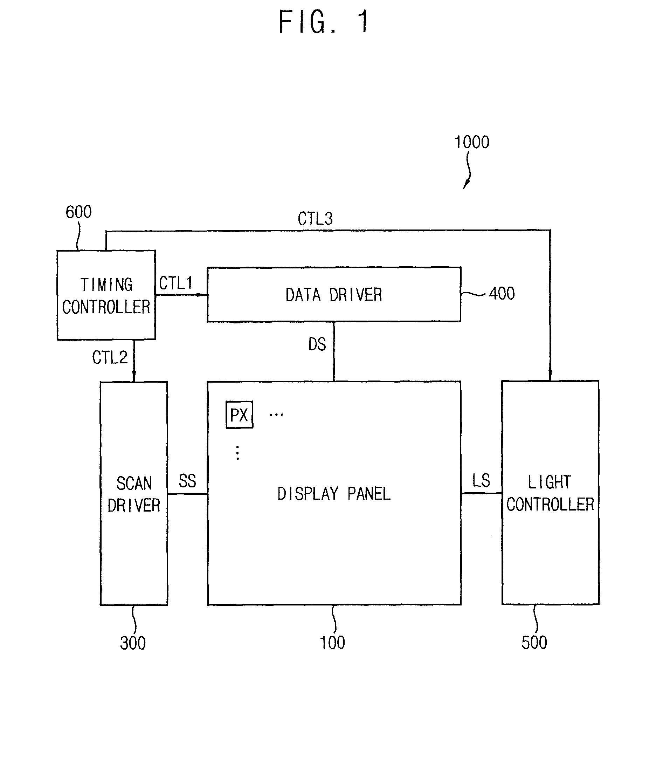

FIG. 1 illustrates a block diagram of a display device according to example embodiments of the invention. Referring to FIG. 1, the display device 1000 may include a display panel 100, a scan driver 300, a data driver 400, a light controller 500, and a timing controller 600.

The display panel 100 may display an image using a plurality of pixels PX. The display panel 100 may include a light control electrode and a filling layer. The display panel 100 may variably control the refractive index of the light in the filling layer using the light control electrode and the common electrode. In one example embodiment, the display panel 100 may be a top emission type display panel, and the index of the light in the filling layer may be controlled and a light emitting efficiency may be improved.

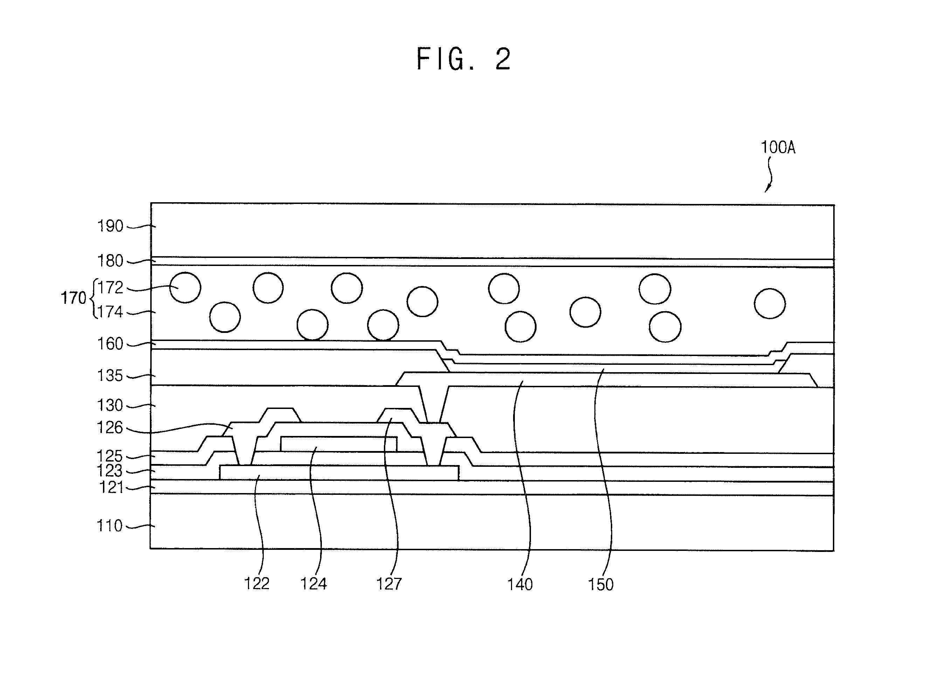

In one example embodiment, the display panel 100 may be an organic light emitting display panel. For example, the display panel 100 may include a first substrate having a thin film transistor that applies a data signal DS in response to a scan signal SS, a pixel electrode electrically connected to the thin film transistor, a common electrode opposing the pixel electrode, an emission layer disposed between the pixel electrode and the common electrode, the emission layer configured to emit a light, a second substrate opposing the first substrate, a light control electrode disposed on the second substrate, a light control signal LS being applying to the light control electrode, and a filling layer disposed between the light control electrode and the common electrode, a refractive index of the filling layer being changed based on a voltage difference between the light control electrode and the common electrode. Hereinafter, a structure of the organic light emitting display panel will be described in detail with reference to the FIGS. 2, 4, and 6.

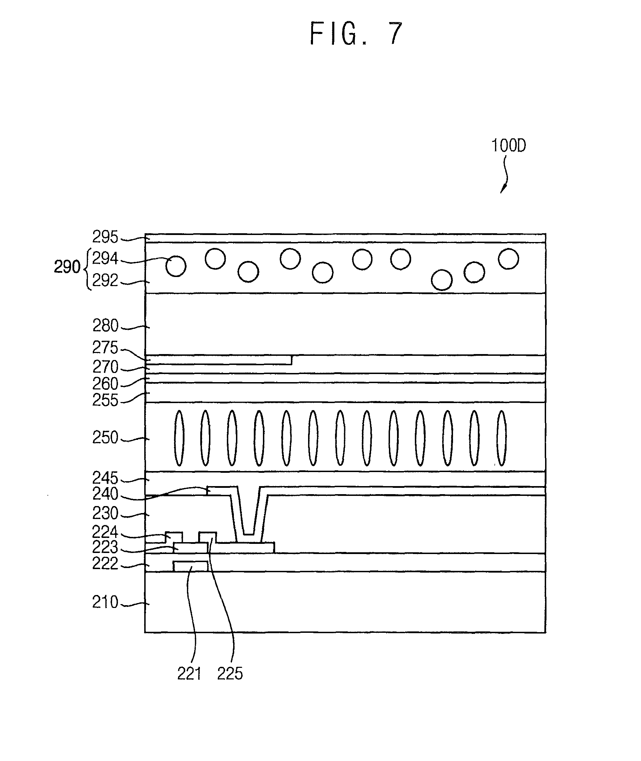

In another example embodiment, the display panel 100 may be a liquid crystal display panel. For example, the display panel 100 may include a first substrate having a thin film transistor that applies a data signal DS in response to a scan signal SS, a pixel electrode electrically connected to the thin film transistor, a second substrate opposing the first substrate, a common electrode disposed on a first side of the second substrate, the common electrode opposing the pixel electrode, a liquid crystal layer disposed between the pixel electrode and the common electrode, a light control electrode disposed on a second side of the second substrate, and a filling layer disposed between the light control electrode and the second substrate, a refractive index of the filling layer being changed based on a voltage difference between the light control electrode and the common electrode. Hereinafter, a structure of the liquid crystal display panel will be described in detail with reference to the FIG. 7.

The scan driver 300 may provide the scan signal SS to the display panel 100 via a plurality of scan lines.

The data driver 400 may provide the data signal DS to the display panel 100 via a plurality of data lines.

The light controller 500 may provide the light control signal LS to the display panel 100. The light controller 500 may form a voltage difference between the light control electrode and the common electrode and control the refractive index of the filling layer by providing the light control signal LS to the light control electrode of the display panel 100.

In one example embodiment, the light controller 500 may adjust a voltage of the light control signal LS based on an intensity of ambient illumination. For example, the light controller 500 may receive ambient illumination information from a sensor sensing the ambient illumination. When an intensity of the ambient illumination is relatively high, the light controller 500 may provide the light control signal LS for decreasing the refractive index of the filling layer to the light control electrode, and the display device 1000 may improve visibility of a displaying image by emitting the light which is concentrated in a forward direction. When the intensity of the ambient illumination is relatively low, the light controller 500 may provide the light control signal LS for increasing the refractive index of the filling layer to the light control electrode, and the display device 1000 may prevent color distortion and widen a viewing angle by dispersing the light.

In another example embodiment, the display panel may include a first pixel region, a second pixel region, and a third pixel region that emit different color lights from each other, and the light controller 500 may independently control voltages of the light control electrodes corresponding to each of the first pixel region, the second pixel region, and the third pixel region. The light controller 500 may independently provide the light control signal LS to each of the light control electrodes that are independently patterned by the color light, and a certain color light may be emphasized at a certain location. For example, the light controller 500 may emphasize a blue color light in a forward direction. The light controller 500 may provide the light control signal LS for decreasing the refractive index of the filling layer corresponding to a blue color pixel region to the light control electrode. The light controller 500 may provide the light control signal LS for increasing the refractive index of the filling layer corresponding to a green color pixel region or a blue color pixel region to the light control electrode.

The timing controller 600 may generate a plurality of timing control signals CTL1, CTL2, and CTL3. The timing controller 600 may provide the timing control signals CTL1, CTL2, and CTL3 to the scan driver 300, the data driver 400, and the light controller 500.

The display device 1000 may widen a viewing angle or improve luminance in a certain direction. To achieve these features, the display panel 100 included in the display device 1000 may only add the filling layer and the light control electrode to control the filling layer, and manufacturing costs may be reduced compared to other manners of achieving these features. The display device 1000 may emphasize a certain color light or a portion, e.g., region, of the display panel 100 using the patterned light control electrode.

FIG. 2 illustrates a cross-sectional view of one example of a display panel included in a display device of FIG. 1. Referring to FIG. 2, the display panel 100A may include a first substrate 110, a pixel electrode 140, an emission layer 150, a common electrode 160, a filling layer 170, a light control electrode 180, and a second substrate 190.

The second substrate 190 may be disposed opposite to the first substrate 110. One of the first substrate 110 or the second substrate 190 may be a base substrate, and the other of the first substrate 110 or the second substrate 190 may be an encapsulation substrate. The first substrate 110 or the second substrate 190 may include a transparent insulation substrate. For example, the first substrate 110 or the second substrate 190 may include a glass substrate, a quartz substrate, or a transparent resin substrate. The transparent resin substrate may include, for example, polyamide resin, acryl resin, polyacrylate resin, polycarbonate resin, polyether resin, polyethylene terephthalate resin, or sulfonic acid resin.

The first substrate 110 may include a thin film transistor. The thin film transistor may include a buffer layer 121, an active layer 122, a gate insulation layer 123, a gate electrode 124, an inorganic insulation layer 125, a source electrode 126, and a drain electrode 127.

A buffer layer 121 may be disposed on the first substrate 110. The buffer layer 121 may prevent diffusion of metal atoms and/or impurities from the first substrate 110. The buffer layer 121 may improve flatness of the surface of the first substrate 110. The active layer 122 may include amorphous silicon, poly silicon and organic semiconductor materials. The gate insulation layer 123 may be disposed on the active layer 122. The gate insulation layer 123 may entirely cover the active layer 122. The gate electrode 124 may be disposed on the gate insulation layer 123 and may overlap the active layer 122. The inorganic insulation layer 125 may be disposed on the gate electrode 124 and may entirely cover the gate electrode 124. The source electrode 126 may be electrically connected to the active layer 122 through a first contact hole that is formed in the gate insulation layer 123 and the inorganic insulation layer 125. For example, the source electrode 126 may contact a first end portion of the active layer 122. The source electrode 126 may partially overlap a first end portion of the gate electrode 124. The drain electrode 127 may be electrically connected to the active layer 122 through a second contact hole that is formed in the gate insulation layer 123 and the inorganic insulation layer 125. For example, the drain electrode 127 may contact a second end portion of the active layer 122. The drain electrode 127 may partially overlap a second end portion of the gate electrode 124.

The organic insulation layer 130 may be disposed on the inorganic insulation layer 125 on which the source electrode 126 and the drain electrode 127 are formed.

The pixel electrode 140 may be disposed on the organic insulation layer 130. The pixel electrode 140 may electrically connected to the drain electrode 127. In one example embodiment, the pixel electrode 140 may be used as an anode electrode that provides the positive holes.

The emission layer 150 may be disposed on the pixel electrode 140. The emission layer 150 may sequentially include a hole injection layer, a hole transfer layer, an organic emission layer, an electron transfer layer, and an electron injection layer. The pixel electrode 140 may provide positive holes to the hole injection layer and the hole transfer layer. The common electrode 160 may provide electrons to the electron transfer layer and the electron injection layer. The positive holes may be combined with the electrons in the organic emission layer to generate light having a desired wavelength.

The common electrode 160 may be disposed on the emission layer 150. In one example embodiment, the common electrode 160 may be used as a cathode that provides electrons.

The pixel defining layer 135 may be disposed on the organic insulation layer 130 on which the pixel electrode 140 is formed. The pixel defining pattern 135 may partially overlap two end portions of the pixel electrode 140. The pixel defining layer 135 may overlap the common electrode 160.

The filling layer 170 may be disposed between the light control electrode 180 and the common electrode 160. A refractive index of the filling layer 170 may be changed based on a voltage difference between the light control electrode 180 and the common electrode 160.

The filling layer 170 may include one or more of a variety of materials whose refractive index is changed by the voltage difference between the light control electrode 180 and the common electrode 160. In one example embodiment, the filling layer 170 may include a polymer dispersed liquid crystal (PDLC). The PDLC may include liquid crystal liquid droplets 172 dispersed in a polymer 174. An orientation of the liquid crystal liquid droplets 172 and the refractive index of the filling layer 170 by scattering of the light in liquid crystal molecules of the liquid crystal droplets 172 may be determined according to the voltage difference between the light control electrode 180 and the common electrode 160.

In one example embodiment, the PDLC may be a positive type liquid crystal. The positive type liquid crystal may arrange the liquid crystal molecules in an electric field direction when the voltage difference between the light control electrode 180 and the common electrode 160 is formed. When the PDLC is a positive type liquid crystal and the voltage difference between the light control electrode 180 and the common electrode 160 is formed, the scattering of the light occurred by the liquid crystal molecules is decreased and the refractive index of the filling layer 170 may be decreased. When the PDLC is a positive type liquid crystal and the voltage difference between the light control electrode 180 and the common electrode 160 is not formed, the scattering of the light is increased because the liquid crystal molecules is arranged in random and the refractive index of the filling layer 170 may be increased. The PDLC may be a positive type liquid crystal in consideration of a manufacturing cost.

In another example embodiment, the PDLC may be a negative type liquid crystal. The negative type liquid crystal may arrange the liquid crystal molecules in an electric field direction when the voltage difference between the light control electrode 180 and the common electrode 160 is not formed. When the PDLC is a negative type liquid crystal and the voltage difference between the light control electrode 180 and the common electrode 160 is not formed, the refractive index of the filling layer 170 may be decreased. When the PDLC is a negative type liquid crystal and the voltage difference between the light control electrode 180 and the common electrode 160 is formed, the refractive index of the filling layer 170 may be increased. The PDLC may be a negative type liquid crystal in consideration of a power consumption and a light emitting efficiency.

The light control electrode 180 may be disposed on the second substrate 190. The light control electrode 180 may receive the light control signal. The light control electrode 180 may include a transparent conductive material. In one example embodiment, the light control electrode 180 may include one or more of indium tin oxide (ITO), indium zinc oxide (IZO), zinc oxide (ZnOₓ), or tin oxide (SnOₓ).

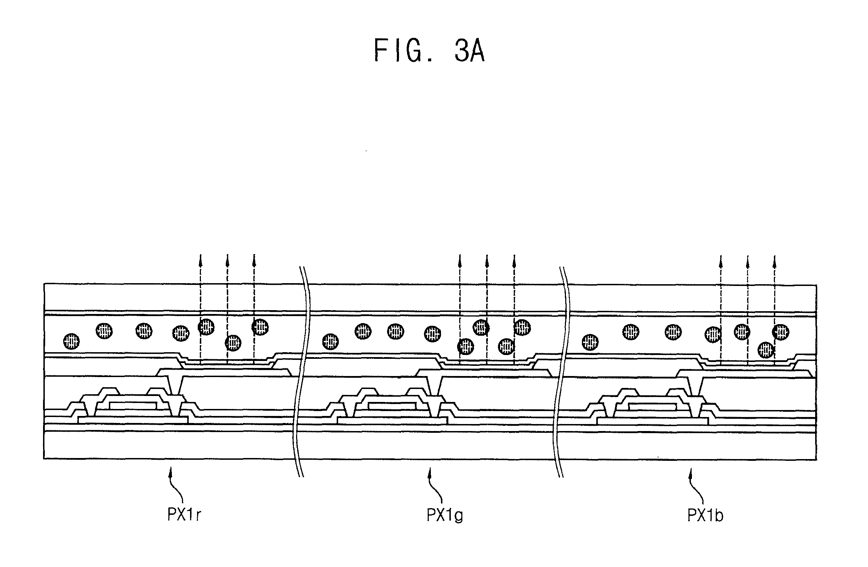

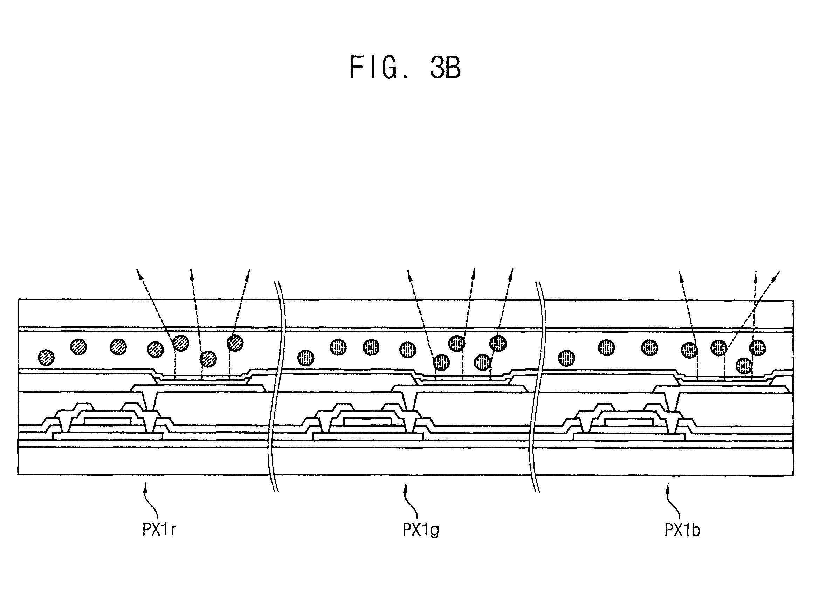

FIGS. 3A and 3B illustrate cross-sectional views of examples of controlling the filling layer included in a display panel of FIG. 2. Referring to FIGS. 3A and 3B, a light control electrode may be commonly formed in all pixels, for example, PX1r, PX1g, and Pxlb, of the display panel. A voltage of the light control electrode may be controlled to commonly control a refractive index of the filling layer in all pixels, for example, PX1r, PX1g, and Pxlb, of the display panel. The display panel may control the refractive index of the filling layer, and luminance in a certain direction may be improved or color distortion may be prevented. In one example embodiment, the voltage of the light control electrode may be controlled based on an intensity of ambient illumination.

As shown in FIG. 3A, the light control electrode may be commonly formed in all pixels, for example, PX1r, PX1g, and Pxlb, of the display panel. The display panel may decrease the refractive index of the filling layer, and luminance in a forward direction may be improved. When the PDLC is a positive type liquid crystal, the light control electrode may be controlled to form an electric field by a voltage difference between the light control electrode and the common electrode such that the refractive index of the filling layer is decreased. Liquid crystal molecules included in the filling layer may be arranged in an electric field direction and a scattering of the light occurred by the liquid crystal molecules is decreased. The refractive index of the filling layer may be decreased, and the light generated by the emission layer may be emitted in a concentrated manner in a forward direction of the display panel. For example, when an intensity of ambient illumination is relatively high, the refractive index of the filling layer may be decreased, and luminance in a forward direction and visibility of a displaying image may be improved. The refractive index of the filling layer may be decreased to narrow a viewing angle for privacy in public places.

As shown in FIG. 3B, the light control electrode may be commonly formed in all pixels, for example, PX1r, PX1g, and Pxlb, of the display panel. The display panel may increase the refractive index of the filling layer, and a viewing angle may be widened. When the PDLC is a positive type liquid crystal, the light control electrode may be controlled to not form an electric field between the light control electrode and the common electrode such that the refractive index of the filling layer is increased. Liquid crystal molecules included in the filling layer may be arranged in random and the scattering of the light occurred by the liquid crystal molecules is increased. The refractive index of the filling layer may be increased, and the light generated by the emission layer may be dispersed. For example, when an intensity of ambient illumination is relatively low, the refractive index of the filling layer may be increased, and luminance in a forward direction may be decreased. The refractive index of the filling layer may be decreased, and a viewing angle may be improved.

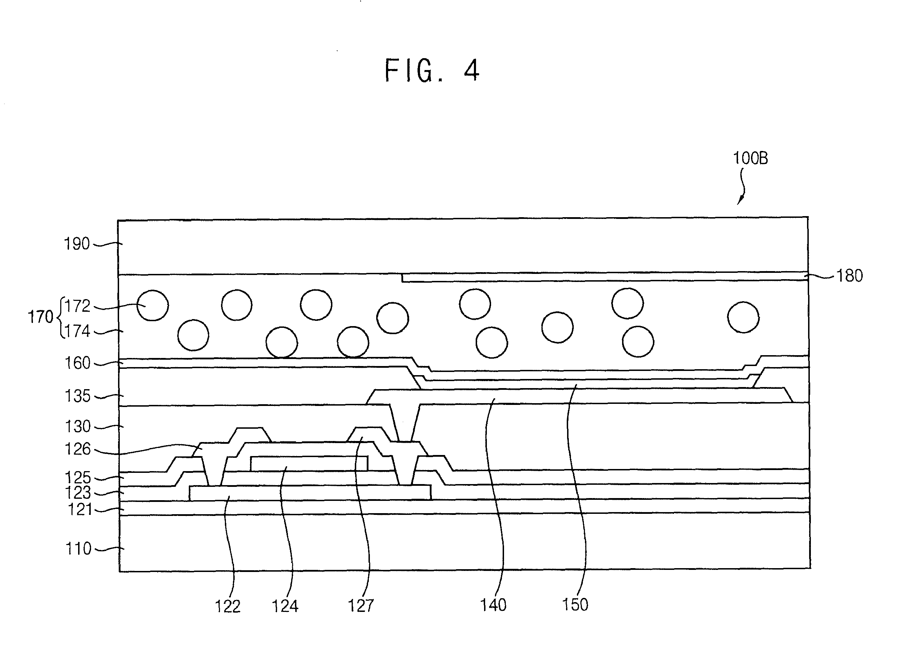

FIG. 4 illustrates a cross-sectional view of another example of a display panel included in a display device of FIG. 1. Referring to FIG. 4, the display panel 100B may include a first substrate 110, a pixel electrode 140, an emission layer 150, a common electrode 160, a filling layer 170, a light control electrode 180, and a second substrate 190. The display panel 100B according to the present embodiment is substantially the same as the display panel of the embodiment described in FIG. 2, except that the light control electrode 180 is patterned. The same reference numerals will be used to refer to the same or like parts as those described in the previous embodiment of FIG. 2, and any repetitive explanation concerning the above elements will be omitted.

The second substrate 190 may be disposed opposite to the first substrate 110. One of the first substrate 110 or the second substrate 190 may be a base substrate, and the other of the first substrate 110 or the second substrate 190 may be an encapsulation substrate. In one example embodiment, the first substrate may include a first pixel region, a second pixel region, and a third pixel region that emit different color lights.

The first substrate 110 may include a thin film transistor. The thin film transistor may include a buffer layer 121, an active layer 122, a gate insulation layer 123, a gate electrode 124, an inorganic insulation layer 125, a source electrode 126, and a drain electrode 127.

The pixel electrode 140 may be disposed on the organic insulation layer 130. The pixel electrode 140 may electrically connected to the drain electrode 127.

The emission layer 150 may be disposed on the pixel electrode 140.

The common electrode 160 may be disposed on the emission layer 150.

The filling layer 170 may be disposed between the light control electrode 180 and the common electrode 160. A refractive index of the filling layer 170 may be changed based on a voltage difference between the light control electrode 180 and the common electrode 160.

The light control electrode 180 may be disposed on the second substrate 190. The light control electrode 180 may receive the light control signal. The light control electrode 180 may be patterned to emphasize a certain color light or to adjust visibility of a portion, e.g., region, of the display panel 100B. In one example embodiment, the display panel 100B may include a first pixel region, a second pixel region, and a third pixel region that emit different color lights. The light control electrode 180 may be independently patterned on each of the first pixel region, the second pixel region, and the third pixel region. Voltages of the light control electrodes corresponding to each of the first pixel region, the second pixel region, and the third pixel region may be independently controlled. The light control electrode 180 may be patterned by each of the color lights, and a certain color light may be emphasized or visibility of a portion, e.g., region, of the display panel 100B may be adjusted.

Although the present embodiment of FIG. 4 describes that the light control electrode 180 is patterned by each of the color lights, the light control electrode 180 can be patterned by various methods and the patterned light control electrodes may be independently controlled.

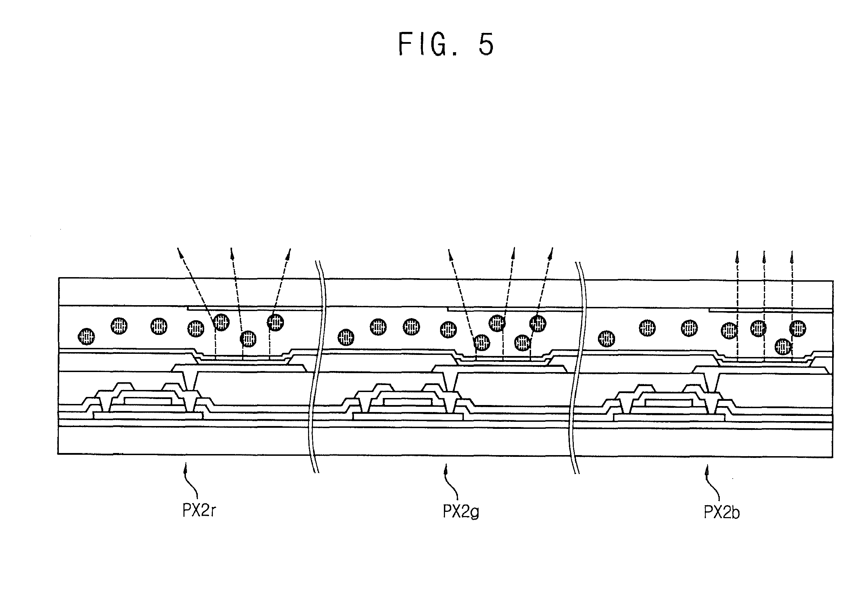

FIG. 5 illustrates a cross-sectional view of an example of controlling the filling layer included in a display panel of FIG. 4. Referring to FIG. 5, a light control electrode may be patterned by each of a red color pixel group PX2r, a green color pixel group PX2g, and a blue color pixel group PX2b. The display panel may independently control voltages of the light control electrodes corresponding to each of the red color pixel group PX2r, the green color pixel group PX2g, and the blue color pixel group PX2b. The display panel may emphasize a certain color light or adjust visibility of a certain region.

For example, the display panel may emphasize the blue color light in a forward direction of the display panel. The display panel may control voltages of the light control electrodes corresponding to the red color pixel group PX2r and the green color pixel group PX2g, and scattering of the red color light and the green color light may be increased. When the PDLC is a positive type liquid crystal, the light control electrodes may be controlled to not form an electric field between the light control electrode and the common electrode that correspond to the red color pixel group PX2r and the green color pixel group PX2g. In an embodiment, the display panel may control a voltage of the light control electrode corresponding to the blue color pixel group PX2b, and scattering of the blue color light may be decreased. When the PDLC is a positive type liquid crystal, the light control electrodes may be controlled to form an electric field by a voltage difference between the light control electrode and the common electrode that correspond the blue color pixel group PX2b. The display panel may increase the scattering of the red color light and the green color light and decrease the scattering of the blue color light, and the blue color light in a forward direction may be emphasized.

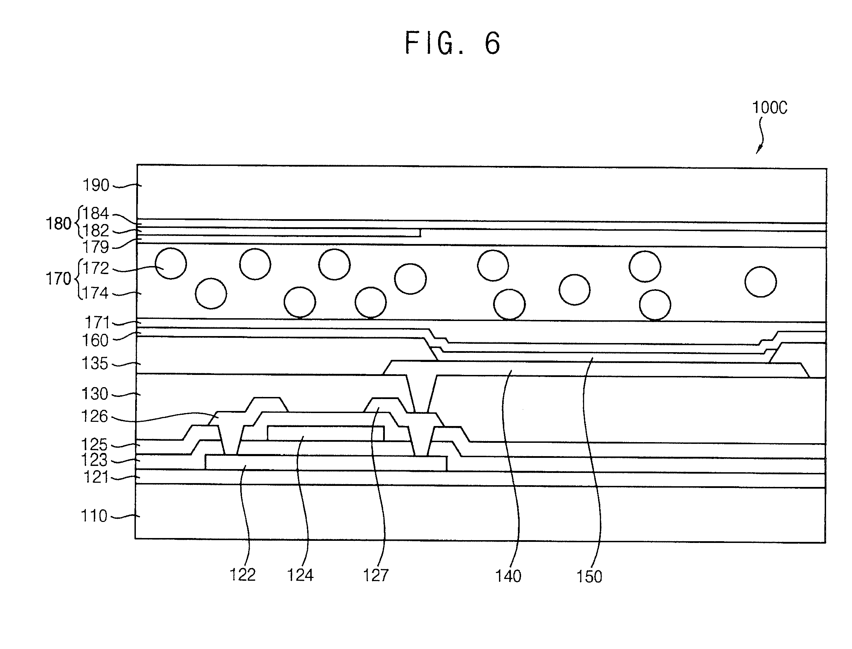

FIG. 6 illustrates a cross-sectional view of still another example of a display panel included in a display device of FIG. 1. Referring to FIG. 6, the display panel 100C may include a first substrate 110, a pixel electrode 140, an emission layer 150, a common electrode 160, a filling layer 170, a first protection layer 171, a second protection layer 179, a light control electrode 180, and a second substrate 190. The display panel 100C according to the present embodiment is substantially the same as the display panel of the embodiment described in FIG. 2, except that the protection layers 171 and 179 are added and the light control electrode 180 has multiple layers. The same reference numerals will be used to refer to the same or like parts as those described in the previous embodiment of FIG. 2, and any repetitive explanation concerning the above elements will be omitted.

The second substrate 190 may be disposed opposite to the first substrate 110. One of the first substrate 110 or the second substrate 190 may be a base substrate, and the other of the first substrate 110 or the second substrate 190 may be an encapsulation substrate.

The first substrate 110 may include a thin film transistor. The thin film transistor may include a buffer layer 121, an active layer 122, a gate insulation layer 123, a gate electrode 124, an inorganic insulation layer 125, a source electrode 126, and a drain electrode 127.

The pixel electrode 140 may be disposed on the organic insulation layer 130. The pixel electrode 140 may electrically connected to the drain electrode 127.

The emission layer 150 may be disposed on the pixel electrode 140.

The common electrode 160 may be disposed on the emission layer 150.

The filling layer 170 may be disposed between the light control electrode 180 and the common electrode 160. A refractive index of the filling layer 170 may be changed based on a voltage difference between the light control electrode 180 and the common electrode 160.

The protection layer 171 and 179 may be disposed on at least one side of the filling layer 170. For example, the first protection layer 171 may be disposed on a first side of the filling layer 170 and the second protection layer 179 may be disposed on a second side of the filling layer 170. The protection layer 171 and 179 may include an organic insulation material or an inorganic insulation material to protect the filling layer 170.

The light control electrode 180 may be disposed on the second substrate 190. The light control electrode 180 may receive the light control signal. The light control electrode 180 may have multiple layers to reduce a deviation of refractive index of the filling layer 170 by voltage drop. The light control electrode 180 may include a transparent electrode and at least one of auxiliary electrode. In one example embodiment, the light control electrode 180 may include a first layer 184 and a second layer 182 disposed at least in part on the first layer 184. The first layer 184 may include a transparent conductive material. In one example embodiment, the light control electrode 180 may include one or more of indium tin oxide (ITO), indium zinc oxide (IZO), zinc oxide (ZnOₓ), or tin oxide (SnOₓ). The second layer 182 may be disposed at least in part on the first layer 184, and an electrical conductivity of the light control electrode 180 may be improved. The second layer 182 may have a low transparency material, the electrical conductivity of the light control electrode 180 may be improved, and the second layer 182 may be disposed at least in part on the first layer 184 corresponding to a non-display region. The second layer 182 may include one or more of cupper (Cu), platinum (Pt), aluminum (Al), silver (Ag), molybdenum (Mo), nickel (Ni), or chrome (Cr).

FIG. 7 illustrates a cross-sectional view of still another example of a display panel included in a display device of FIG. 1. Referring to FIG. 7, the display panel 100D may be a liquid crystal display panel. The display panel 100D may include a first substrate 210, a pixel electrode 240, a liquid crystal layer 250, a common electrode 260, a second substrate 280, a filling layer 290, and a light control electrode 295.

The second substrate 280 may be disposed opposite to the first substrate 210. One of the first substrate 210 or the second substrate 280 may be a base substrate, and the other of the first substrate 210 or the second substrate 280 may be an encapsulation substrate. The first substrate 210 or the second substrate 280 may include a transparent insulation substrate. For example, the first substrate 210 or the second substrate 280 may include a glass substrate, a quartz substrate, or a transparent resin substrate.

The first substrate 210 may include a thin film transistor. The thin film transistor may include a gate electrode 221, a first insulation layer 222, an active layer 223, a source electrode 224, and a drain electrode 225.

The gate electrode 221 may be disposed on the first substrate 210 and electrically connected to a scan line. The first insulation layer 222 may be disposed on the gate electrode 221 and electrically insulate the gate electrode 221 from other elements. The first insulation layer 221 may include silicon oxide (SiOₓ) and silicon nitride (SiNₓ). The active layer 223 may be disposed on the first insulation layer 222. The active layer 223 may overlap the gate electrode 221. The active layer 223 may include, for example, an amorphous silicon, a poly silicon, or an organic semiconductor. The source electrode 224 may be disposed on the active layer 223 and electrically connected to a data line that crosses the scan line. The source electrode 224 partially may overlap the gate electrode 221. The drain electrode 225 may be disposed on the active layer 223. The drain electrode 225 may partially overlap the gate electrode 221 and may be spaced apart from the source electrode 224.

The second insulation layer 230 may be disposed on the first insulation layer 222 on which the source electrode 224 and the drain electrode 225 are disposed. The second insulation layer 230 may electrically insulate the source electrode 224, the active layer 223, and the drain electrode 225 from other elements. The second insulation layer 230 may include silicon oxide (SiOx) and silicon nitride (SiNx).

The pixel electrode 240 may be disposed on the second insulation layer 230. The pixel electrode 240 may be electrically connected to the drain electrode 225 through a contact hole which is formed on the second insulation layer 120 and which partially exposes the drain electrode 225.

The liquid crystal layer 250 may be disposed between the pixel electrode 240 and the common electrode 260. The liquid crystal layer 250 may include liquid crystal molecules having optical anisotropy. The liquid crystal molecules may be driven by an electric field. An image may be displayed by passing or blocking light through the liquid crystal layer 250.

A first alignment layer 245 and a second alignment layer 255 may be formed on both sides of the liquid crystal layer 250. The first alignment layer 245 may be disposed on the pixel electrode 240 and the second insulation layer 230, and the second alignment layer 255 may be disposed on the common electrode 260.

The common electrode 260 may be disposed on the second substrate 280 and opposite the pixel electrode 240.

The black matrix 275 may be disposed under the second substrate 280. The black matrix 275 may correspond to an area except for the display region to block the light. For example, the black matrix 275 may overlap the thin film transistor, the data line and the scan line.

The color filter 270 may be disposed under the black matrix 275 and the second substrate 280. Light passing through the color filter 270 from the liquid crystal layer 250 has a color. The color filter 270 may include a red color filter, a green color filter or blue color filter. The color filter 270 may correspond to the display region. Color filters adjacent to each other may have different colors, respectively.

The filling layer 290 may be disposed between the light control electrode 295 and the second substrate 280. A refractive index of the filling layer 290 may be changed based on a voltage difference between the light control electrode 295 and the common electrode 260. The filling layer 290 may include one or more of a variety of materials whose refractive index is changed by the voltage difference between the light control electrode 295 and the common electrode 260. In one example embodiment, the filling layer 290 may include a polymer dispersed liquid crystal (PDLC). The PDLC may include liquid crystal liquid droplets 294 dispersed in a polymer 292. An orientation of the liquid crystal liquid droplets 294 and the refractive index of the filling layer 290 by scattering of the light in liquid crystal molecules of the liquid crystal droplets 294 may be determined according to the voltage difference between the light control electrode 295 and the common electrode 260. Since the filling layer 290 is described above, duplicated descriptions will be omitted.

The light control electrode 295 may be disposed on a second side of the second substrate 280 and may receive the light control signal.

The display panel 100D may include the filling layer 290 and the light control electrode 295, and the refractive index of the light may be variably controlled and visibility of a displaying image may be improved.

Example embodiments of the invention have been disclosed herein, and although specific terms are employed, they are used and are to be interpreted in a generic and descriptive sense only and not for purpose of limitation. In some instances, as would be apparent to one of skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A display panel, comprising:
a first substrate including a transistor;
a pixel electrode electrically connected to the transistor;
a common electrode opposing the pixel electrode;
an emission layer between the pixel electrode and the common electrode, the emission layer adapted to emit light;
a second substrate opposing the first substrate;
a light control electrode on the second substrate; and
a filling layer between the light control electrode and the common electrode, a refractive index of the filling layer being determined by a voltage difference between the light control electrode and the common electrode.

2. A display panel as claimed in claim 1, wherein the filling layer includes a polymer dispersed liquid crystal (PDLC).

3. A display panel as claimed in claim 2, wherein the PDLC is a positive type liquid crystal.

4. A display panel as claimed in claim 2, wherein the PDLC is a negative type liquid crystal.

5. A display panel as claimed in any preceding claim, wherein the light control electrode includes a first layer including a transparent conductive material.

6. A display panel as claimed in claim 5, wherein the first layer includes one or more of indium tin oxide (ITO), indium zinc oxide (IZO), zinc oxide (ZnOₓ), or tin oxide (SnOₓ).

7. A display panel as claimed in claim 5 or 6, wherein the light control electrode further includes a second layer at least in part on the first layer.

8. A display panel as claimed in claim 7, wherein the second layer includes one or more of cupper (Cu), platinum (Pt), aluminum (Al), silver (Ag), molybdenum (Mo), nickel (Ni), or chrome (Cr).

9. A display panel as claimed in any preceding claim, wherein a voltage of the light control electrode is controlled based on an intensity of ambient illumination.

10. A display panel as claimed in any preceding claim, wherein:
the first substrate includes a first pixel region, a second pixel region, and a third pixel region that emit different color lights, and
the light control electrode is independently patterned on each of the first pixel region, the second pixel region, and the third pixel region.

11. A display panel as claimed in claim 10, wherein voltages of the light control electrodes corresponding to each of the first pixel region, the second pixel region, and the third pixel region are independently controlled.

12. A display panel as claimed in claim 1, further comprising a protection layer on at least one side of the filling layer.

13. A display device, comprising:
a display panel;
a scan driver providing a scan signal to the display panel;
a data driver providing a data signal to the display panel; and
a light controller providing a light control signal to the display panel,
the display panel including:
a first substrate including a transistor providing the data signal in response to the scan signal;
a pixel electrode electrically connected to the transistor;
a common electrode opposing the pixel electrode;
an emission layer between the pixel electrode and the common electrode, the emission layer emitting light;
a second substrate opposing the first substrate;
a light control electrode on the second substrate, the light control signal being applied to the light control electrode; and
a filling layer between the light control electrode and the common electrode, a refractive index of the filling layer being changed based on a voltage difference between the light control electrode and the common electrode.

14. A display device as claimed in claim 13, wherein:
the display panel includes a first pixel region, a second pixel region, and a third pixel region that emit different color lights, and
the light control electrode is independently patterned on each of the first pixel region, the second pixel region, and the third pixel region.

15. A display device as claimed in claim 14, wherein the light controller is adapted to independently control voltages of the light control electrodes corresponding to each of the first pixel region, the second pixel region, and the third pixel region.
